# EUROPEAN PATENT APPLICATION

(11) **EP 4 786 990 A1**
(43) Date of publication of application: **05.08.2026**
(21) Application number: 26155057.8
(22) Date of filing: 29.01.2026
(51) Int. Cl.: G01R 1/07, G01R 31/28, G01R 31/312

(54) **CONTACTLESS TESTING OF INTERPOSERS AND SILICON BRIDGES**

(30) Priority: 30.01.2025 US 202563751768 P; 09.09.2025 US 202519324010
(71) Applicant: ADVANTEST CORPORATION, Chiyoda-ku Tokyo 100-0005 (JP)
(72) Inventor: SAUER, Matthias, Tokyo, 100-0005 (JP); SERRER, Jürgen, Tokyo, 100-0005 (JP); ROTTACKER, Markus, Tokyo, 100-0005 (JP); HARJUNG, Rolf, Tokyo, 100-0005 (JP); BIANCHI, GIOVANNI, Tokyo, 100-0005 (JP)
(74) Representative: Parker, Andrew James

(57) **Abstract**

In various embodiments, a computer-implemented method for testing an interposer or silicon bridge comprises moving, by automated test equipment, a probe proximate to a first contact of a device under test (DUT), moving, by the automated test equipment, a second probe proximate to a second contact of the DUT, where the first contact and second contact are connected via a wire, driving, by the automated test equipment, the first probe with a first RF signal to induce a second RF signal in the wire, measuring, by the automated test equipment via the second probe, the second RF signal, and generating, by the automated test equipment, a test result based on at least the second RF signal.

## Description

### CROSS-REFERENCE TO RELATED APPLICATIONS

This application claims priority benefit of United States Provisional Patent Application titled, "CONTACTLESS TESTING OF INTERPOSERS AND SILICON BRIDGES," filed on January 30, 2025, and having Serial No. 63/751,768. The subject matter of this related application is hereby incorporated herein by reference.

### BACKGROUND

### Field of the Various Embodiments

This application relates to systems and methods for reliable test tooling for packaged integrated circuits (IC) devices, and more specifically, to contactless testing of interposers and silicon bridges.

### Description of the Related Art

Interposers and silicon bridges are typically used in various electronic assemblies to provide electrical interface routing between connections in a socket or on an integrated circuit. An interposer or silicon bridge includes various contact pads, such as solder balls or pins, with conductive traces and/or metallization between the contact pads that provide the interface routing.

Like other devices, interposers and silicon bridges need to be tested to determine that the conductive traces and/or metallization is making adequate connection between the appropriate contact pads and that there are no shorts, opens, or other flaws that might prevent the interposers and silicon bridges from operating correctly. In some cases, the interposers are tested after partial assembly, such as within an assembly of a high-performance computing (HPC) device. However, such testing is performed after a large portion of the assembly is fabricated and combined. Identifying failures in a partial assembly is more costly and time consuming. In other cases, various testing systems perform contact testing of interposers and silicon assemblies before adding the components to an electronic assembly. Testing such components in this manner reduces costs and time associated with identifying failed components. Other testing systems employ non-contact approaches, such as systems that rely on x-ray, e-beam, or other imaging approaches.

At least one drawback of testing systems is that such systems have difficulty efficiently testing interposers and silicon bridges efficiently. For example, various testing systems perform a test of a given wiring route within the interposer or silicon assembly by establishing physical contacts with contact pads that are connected via the conductive trace or metallization and measuring signals to detect failure conditions, such as a short or an open. The testing system performs tests for each route included in the interposer or silicon assembly in a combination of a sequential and parallel fashion. However, the contact pads for a given interposer might not be easily contactable during testing. The small sizes and pitches of a given contact pad can block attempts by the testing equipment to physically contact the contact pad being tested without physically contacting neighboring contact pads. Contacting neighboring contact pads during tests degrades the measurements recorded by the testing system and causes the testing systems to generate false results. In addition, the contact pads might be damaged if physically contacted by a testing probe included in the testing system. Existing non-contact systems relying on imaging approaches require large and expensive testing apparatuses that are not compatible with typical semiconductor testing systems, or have a limited accuracy in detecting defects. Further, conventional testing systems sequentially test and evaluate each conductive lead or wire in a device such as an interposer, resulting in long testing times associated with testing each wire or conductive route in a DUT. Consequently, such testing systems greatly increase costs and time associated with testing complex electronic assemblies that include interposers or silicon bridges.

In view of the foregoing, what is needed in the art is an improved technique for testing interposers and silicon bridges.

### SUMMARY

In various embodiments, a computer-implemented method for testing an interposer or silicon bridge comprises moving, by automated test equipment, a probe proximate to a first contact of a device under test (DUT). The computer-implemented method also includes moving, by the automated test equipment, a second probe proximate to a second contact of the DUT, where the first contact and second contact are connected via a wire. The computer-implemented method further includes driving, by the automated test equipment, the first probe with a first RF signal to induce a second RF signal in the wire. The computer-implemented method further includes measuring, by the automated test equipment via the second probe, the second RF signal, and generating, by the automated test equipment, a test result based on at least the second RF signal.

At least one technical advantage of the disclosed techniques relative to the prior art is that, with the disclosed techniques, interposers, silicon bridges, and other electronic equipment can be tested quickly and accurately using a contactless approach without the need of bulky and costly imaging-based systems. In particular, the contactless approach moves probes proximate to the DUT and performs one or more electrical tests that typically require contact between a pair of contact points on the DUT and the testing system. In this manner, a testing system using the contactless approach can acquire accurate results without damaging the DUT or introducing false measurements due to contact errors. The disclosed techniques also accurately identify faults, such as opens, shorts, and potential failures of neighboring wires, at greater speeds and at lower costs than conventional contactless testing systems. Further, the disclosed techniques can identify functioning wires and faults with greater accuracy. These technical advantages provide one or more technological advancements over prior art approaches.

### BRIEF DESCRIPTION OF THE DRAWINGS

So that the manner in which the above recited features of the various embodiments can be understood in detail, a more particular description of the inventive concepts, briefly summarized above, can be had by reference to various embodiments, some of which are illustrated in the appended drawings. It is to be noted, however, that the appended drawings illustrate only typical embodiments of the inventive concepts and are therefore not to be considered limiting of scope in any way, and that there are other equally effective embodiments.
Figure 1 illustrates a block diagram of a contactless testing system performing a test of a device under test (DUT), according to various embodiments.
Figure 2 illustrates a conceptual diagram of the contactless testing system of Figure 1 interacting with a DUT, according to various embodiments.
Figure 3 illustrates example RF probes of the contactless testing system of Figure 2 in proximity to the wire of the DUT, according to various embodiments.
Figure 4 illustrates a testing arrangement for a plurality of contact pads of a DUT of Figure 2, according to various embodiments.
Figure 5 illustrates a graph of a plurality of measurement RF signals received by the contactless testing system of Figure 2, according to various embodiments.
Figure 6 is a flow diagram of method steps for testing of a device under test, according to various embodiments.

### DETAILED DESCRIPTION

In the following description, numerous specific details are set forth to provide a more thorough understanding of the various embodiments. However, it will be apparent to one skilled in the art that the inventive concepts can be practiced without one or more of these specific details.

A contactless testing system disclosed herein enables interface routes of interposers and/or silicon bridges to be tested and evaluated without requiring contact with any leads, contact pads, solder balls, or pins of the interposers and/or silicon bridges. The contactless testing system includes a plurality of RF probes that are configured to establish capacitive couplings with contact leads of a DUT. The DUT can be a device that includes an interface under test (IUT), such as interface wiring. For example, the DUT can be an interposer or a silicon bridge that includes a wire or interface wiring as the IUT. During testing, a probe card connected to the RF probes responds to commands by moving the RF probes to a desired location and a desired position proximate to one or more target contact leads on the DUT. The probe card moves the RF probes along the x-axis, y-axis, and/or z-axis and can tilt the RF probes to modify orientations relative to the DUT. Alternatively, in some embodiments, the DUT is moved on the x-axis, y-axis, and/or z-axis to modify orientations relative to the probe. A given RF probe includes a cable that can be extended to change the distance between the distal end of the RF probe and a target contact pad. Once at the target positions, a source RF probe couples (e.g., capacitively couples) with a first contact pad and a receiving RF probe couples with a corresponding second contact pad, each without making contact. The number of source RF probes do not need to match the number of receiving RF probes. For example, six source RF probes can couple with six contact pads that act as sources, and three receiving RF probes can couple with three contact pads that act as receptors. An RF tester generates a test signal at a selected frequency. The source RF probe induces the wire connected to the corresponding first contact pad coupled to the source RF probe to transmit the RF test signal. The receiving RF probe receives a corresponding measurement RF signal from the corresponding second contact pad. In some embodiments, the contactless testing system generates multiple RF test signals in parallel and each of the receiving RF probes receives multiple measurement RF signals. The probe transmits the one or more measurement RF signals to a testing module. The testing module analyzes the one or more measurement RF signals and identifies any performance test failures. The testing module provides one or more the measurement RF signals, and the performance test results for evaluation of the device under test.

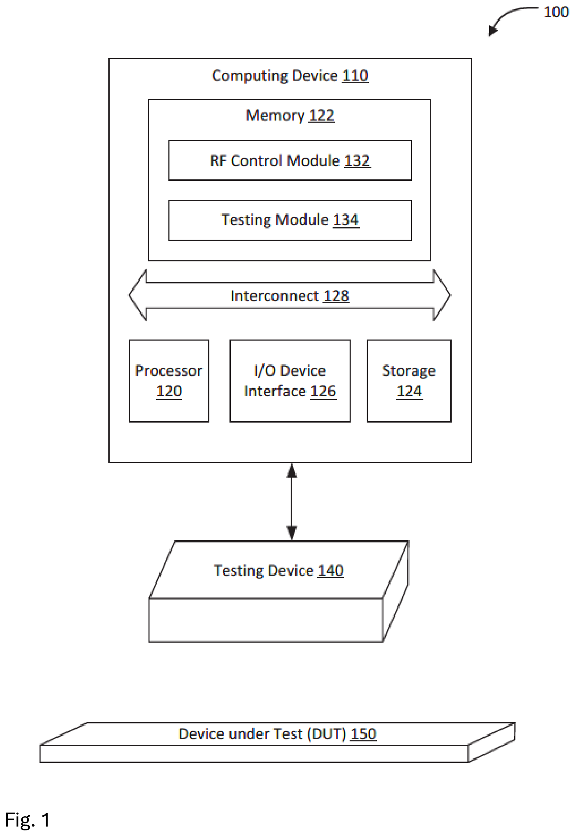

Figure 1 illustrates a block diagram of a contactless testing system 100 performing a test of a device under test (DUT) 150, according to various embodiments. As shown, the contactless testing system 100 includes, without limitation, a computing device 110 and a testing device 140. The computing device 110 includes, without limitation, a processor 120, a memory 122, storage 124, an input/output (I/O) device interface 126, and an interconnect 128. The memory 122 includes, without limitation, a radio frequency (RF) control module 132 and a testing module 134.

In operation, the processor 120 executes instructions from the one or more modules 132, 134 stored in the memory 122 to control the testing device 140. In such instances, a given module 132, 134 can receive data from the testing device 140 and can transmit commands to the testing device 140 to control the operation of the testing device 140. Such operations include movement of the testing device 140 (e.g., a probe card, one or more probe carriers, one or more probes, etc.) and/or operation of one or more electrical tests on the DUT 150.

The computing device 110 is configured to implement one or more aspects of the various embodiments. In some examples, the computing device 110 individually controls one or more probes, probe cards, testers, and/or other components of the contactless testing system 100. In various embodiments, the computing device 110, a controller device (not shown) that is included in the testing device 140, and/or other components (e.g., probes, cables, and connectors) of the testing device 140 can also work in concert to control the position and/or orientation of one or more probes and control the flow of electricity during electrical tests to test one or more components of the DUT 150. The computing device 110 is also configured to receive one or more measurement signals from the testing device 140, compare the one or more measurement signals to one or more predetermined and/or configurable thresholds and record a quality control result (e.g., pass, fail and/or the like) based on the comparison.

In some embodiments, the computing device 110 includes a processor 120, a memory 122, a storage 124, an I/O device interface 126, and an interconnect 128. The computing device 110 includes a desktop computer, a laptop computer, a smart phone, a personal digital assistant (PDA), tablet computer, or any other type of computing device configured to receive input, process data, and optionally display images, and is suitable for practicing one or more embodiments. The computing device 110 described herein is illustrative and any other technically feasible configurations that fall within the scope of the present disclosure.

The processor(s) 120 includes any suitable processor implemented as a central processing unit (CPU), a graphics processing unit (GPU), an application-specific integrated circuit (ASIC), a field programmable gate array (FPGA), an artificial intelligence (AI) accelerator, any other type of processor, or a combination of different processors, such as a CPU configured to operate in conjunction with a GPU. In general, the processor(s) 120 can be any technically feasible hardware unit capable of processing data and/or executing software applications. Further, in the context of this disclosure, the computing elements shown in the computing device 110 can correspond to a physical computing system (e.g., a system in a data center) or can be a virtual computing instance executing within a computing cloud.

The I/O device interface 126 enables communication of I/O devices with the processor(s) 120. The I/O device interface 126 generally includes the requisite logic for interpreting addresses corresponding to I/O devices that are generated by the processor(s) 120. I/O device interface 126 can also be configured to implement handshaking between the processor(s) 120 and the I/O devices, and/or generate interrupts associated with I/O devices. I/O device interface 126 can be implemented as any technically feasible CPU, ASIC, FPGA, any other type of processing unit or device. I/O devices include devices capable of providing input, such as a keyboard, a mouse, a touch-sensitive screen, a microphone, a remote control, a camera, and so forth, as well as devices capable of providing output, such as a display device. Additionally, I/O devices can include devices capable of both receiving input and providing output, such as a touchscreen, a universal serial bus (USB) port, and so forth. I/O devices can be configured to receive various types of input from an end-user of the computing device 110, and to also provide various types of output to the end-user of the computing device 110, such as displayed digital images or digital videos or text. In some embodiments, one or more of the I/O devices are configured to couple the computing device 110 to a network. A network includes any technically feasible type of communications network that allows data to be exchanged between the computing device 110 and external entities or devices, such as a web server or another networked computing device. For example, a network can include a wide area network (WAN), a local area network (LAN), a wireless (Wi-Fi) network, and/or the Internet, among others.

The memory 122 includes a random access memory (RAM) module, a flash memory unit, or any other type of memory unit or combination thereof. The processor(s) 120, the I/O device interface 126, and the network interface are configured to read data from and write data to the memory 122. The memory 122 includes various software programs that can be executed by the processor(s) 120 and application data associated with said software programs, including the RF control module 132 and the testing module 134 that performs individualized and/or group electrical tests on the DUT 150.

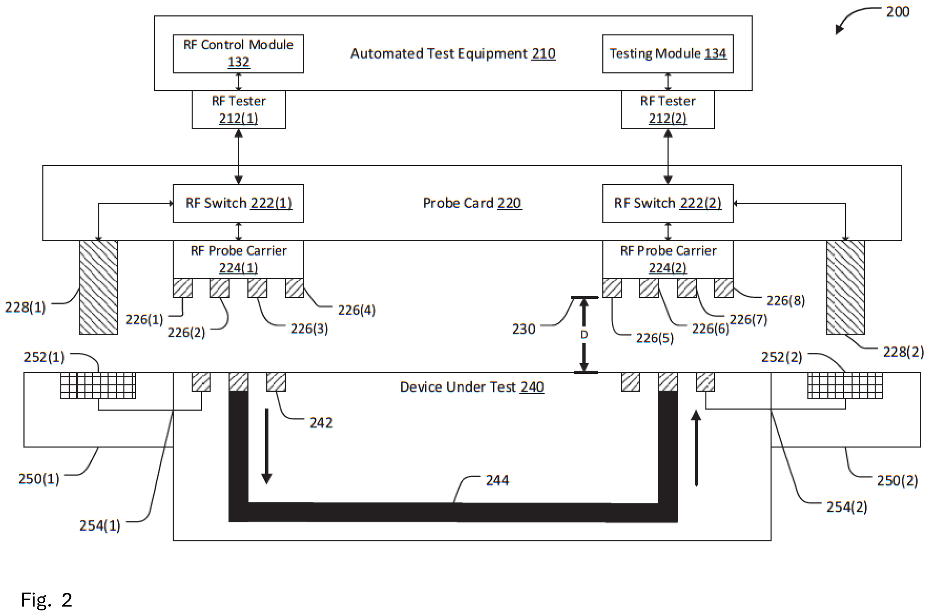

In various embodiments, the RF control module 132 included in the computing device controls one or more components of the testing device 140 and/or the computing device 110 when performing one or more electronic tests. As will be discussed in greater detail with respect to Figures 2-6, the RF control module 132 can control the positioning of one or more probes relative to the DUT 150 and can drive the generation of a test RF signal. Based on one or more capacitive couplings between the testing device 140 and the DUT 150, the test RF signal induces a corresponding RF signal in an IUT (e.g., interface wiring) included in the DUT 150. In some embodiments, the RF control module 132 can acquire data to determine the position of the probes. For example, the RF control module 132 can acquire image data (e.g., via a camera) and/or sensor data (e.g., laser measurements, sonic data, mechanical data, magnetic data) to determine the position of the probes along the x, y, and z axes, as well as determine an orientation (e.g., tilt relative to a plane of the testing device 140 and/or the DUT 150).

For example, the RF control module 132 can process the sensor data to determine the location and orientation of the probe. The RF control module 132 can then use the location and orientation to verify whether the probe is at a target distance that is proximate to the DUT 150 at the one or more contact pads. When the RF control module 132 determines that the probe 226 is not at the applicable position or orientation, the RF control module 132 can send one or more commands to the testing device 140 to adjust the position of the probe. In such instances, the RF control module 132 can iteratively process data acquired by the testing device 140 and generate commands to adjust the testing device 140 before completing verification and generating the test RF signal.

In various embodiments, the testing module 134 can include one or more types of components that perform various types of tests on the DUT 150. For example, the testing modules 134 can comprise a vector network analyzer (VNA) module, an electrical RF testing module, a circuit analysis module, and so forth. In such instances, one of the testing modules 134 can select a particular test to run (e.g., an S-parameter test) and the computing device 110 generates one or more commands to move the testing device 140 to a target location relative to the DUT 150. In various embodiments, the testing device 140 records signals detected from the DUT 150 and identifies insertion loss and return loss. For example, the testing module 134 can measure yields of RF signal characteristics, such as waveforms, S-parameters, conductivity, resistance, signal characteristics (amplitude, phase, steepness of change, frequency spectrum, etc.), and so forth. Additionally, or alternatively, the testing device 140 can acquire the electrical measurements to enable the testing module 134 to identify performance test failures (e.g., shorts, opens, resonant frequencies, etc.). In such instances, the computing device 110 provides the electrical measurements and any performance test failures for evaluation of the DUT 150 via the I/O device interface 126.

Storage 124 includes non-volatile storage for applications and data, and can include fixed or removable disk drives, flash memory devices, and CD-ROM, DVD-ROM, Blu-Ray, HD-DVD, or other magnetic, optical, or solid state storage devices. The storage 124 can be a disk drive storage device. Although shown as a single unit, the storage 124 can be a combination of fixed and/or removable storage devices, such as fixed disc drives, floppy disc drives, tape drives, removable memory cards, or optical storage, network attached storage (NAS), or a storage area-network (SAN). Software programs, including one or more LED testing applications that perform individualized and/or group LED tests can be stored in storage 124 and loaded into memory 122 when executed.

The interconnect 128 is inclusive of any technically feasible internal and/or external data busses, memory busses, system busses, expansion busses and/or the like. The interconnect 128 includes a collection of electrical pathways that allows data, addresses, and control signals to be transferred between the various components of the computing device 110 and/or external devices and components. While discussed in the singular for clarity, the interconnect 128 is illustrative of one or more interconnects 128 that connect, for example, the processor 120 to the memory 122 and/or the storage 124, connects the computing device 110 to other devices including the testing device 140, I/O devices, peripheral devices, other computing devices, and/or the like. In some embodiments, the interconnect 128 includes PCI Express (PCIe) connections for highspeed internal connections and Universal Serial Bus (USB) connections for connecting external devices.

The DUT 150 can be one of various types of electronic components. for example, the DUT 150 can be an interposer, a silicon bridge, a silicon interposer (SIP), an embedded multi-die interconnect bridge (EMIB), a local silicon interconnect (LSI), etc. In various embodiments, the DUT 150 includes one or more interfaces under test (IUT) (not shown). In such instances, the contactless testing system 100 can test one or more IUTs by positioning the testing device 140 to couple with the applicable connected pair of contact pads on the DUT 150. For example, the contactless testing system 100 can test a plurality of IUTs in parallel by positioning a probe such that multiple probes couple with respective contact pads simultaneously. In such instances, the contactless testing system 100 can generate a plurality of test RF signals in parallel to induce different currents in different IUTs.

Figure 2 illustrates a conceptual diagram of the contactless testing system 100 of Figure 1 interacting with a DUT 240, according to various embodiments. As shown, the contactless testing system 200 includes, without limitation, automated testing equipment 210, a probe card 220, and a testing interface 250. The DUT 240 includes, without limitation, a plurality of contact pads 242, and a plurality of wires 244. The automated testing equipment 210, includes, without limitation, the RF control module 132, the testing module 134, and one or more RF testers 212. The probe card 220 includes, without limitation, zero, one, or more RF switches 222, zero, one, or more RF probe carriers 224, zero, one, or more contactless probes 226, and zero, one, or more contact probes 228. The testing interface 250 includes, without limitation, one or more large contact pads 252 and one or more connection lines 254.

In various embodiments, the DUT 240 could be an interposer that includes a plurality of wires 244 that are to be tested. In such instances, the automated test equipment 210 is configured to use the probe card 220 to test the IUTs included in the DUT 240. Before initiating a test, the RF control module 132 transmits commands to the probe card 220. The commands include a command for the RF switch 222 to select an RF probe (e.g., the RF probe carrier 224(1)) and one or more contactless probes 226 (e.g., probes 226(1) - 226(4)) to act as a source, and select another RF probe (e.g., the RF probe carrier 224(2)) and one or more contactless probes 226 (e.g., probes 226(5) - 226(8)) to act as a receptor. The RF control module 132 transmits commands to move the selected RF probe carriers 224 and/or the selected contactless probes 226 to target positions and/or target orientations relative to target contact pads 242 on the DUT 240. Once moved to the target position, a source contactless probe 226 (e.g., the contactless probe 226(2)) in the source RF probe carrier 224(1) is coupled to the target contact pad 242 via capacitive coupling. One of the RF control module 132 or the testing module 134 drives the source RF tester 212 (e.g., the RF tester 212(1)) to generate a test RF signal. Due to the coupling between the source contactless probe 226(2) and the contact pad 242, the source contactless probe 226(2) induces a current in the IUT (e.g., the wire 244). A receiving contactless probe 226 (e.g., the contactless probe 226(6)) of the receiving RF probe carrier 224(2) receives a measurement RF signal corresponding to the current in the wire 244. The receiving RF probe carrier 224 transmits the measurement RF signal to the testing module 134 via the receiving RF tester 212(2). The testing module 134 analyzes the measurement RF signal to identify any failures associated with the wire 226 and determines whether the DUT 240 is faulty. In various embodiments, the RF control module 132 selects a plurality of wires 244 to test in parallel. In such instances, the RF control module 132, selects a plurality of contact pads 242 for coupling and the RF switches 222 selects a plurality of contactless probes 226(1)-226(8) from the plurality of RF probe carriers 224 to couple with the selected plurality of contact pads 242. In some embodiments, the RF switch 222(1) is included in the probe card 220. Alternatively, in some embodiments, the RF switch 222(1) is included in the ATE 210.

In various embodiments, the RF control module 132 verifies that the probe distance 230 ("D") between a given contactless probe 226 and the target contact pad 242 is within a threshold range (e.g., 1 to 10 µm) to enable capacitive coupling and reductions in distance-based signal loss. In such instances, the RF control module 132 can acquire and process image data (e.g., via a camera) and/or other types of sensor data (e.g., laser measurements, sonic data, mechanical data, magnetic data, etc.) to determine the position of the contactless probe 226 and generate commands to move the contactless probe 226 within the threshold range. In some embodiments, the probe card 220 can include one or more distance sensors to aid the RF control module 132 to determine the probe distance 230 and/or a tilt of the contactless probe 226 relative to the plane of the DUT 240.

In various embodiments, the RF probe carrier 224 can direct a beam of the test RF signal to the target contact pad 242. Additionally, or alternatively, the RF control module 132 can control the RF probe carrier 224 to use various beamforming methods to couple parallel probes 226 with parallel contact pads 242. In such instances, the RF control module 132 can parallelize the coupling of the RF probe carrier 224 to a plurality of contact pads 242 and can drive the RF tester 212 to generate multiple test RF signals (e.g., a distinct test RF signal for each contact pad 242 coupled to the RF probe carrier 224). In this manner, the contactless testing system 200 can test multiple wires 244 in parallel by receiving multiple measurement RF signals in parallel and identifying any failures.

In some embodiments, the DUT 240 connects to the testing interface 250. For example, one of the contact pads 242 can connect to a large contact pad 252(1) (e.g., a testing contact) via a connection line 254(1) in a testing mount that comprises the testing interface 250. In such instances, the probe card 220 can electrically couple to the contact pad 242 included in the DUT 240 when the contact probe 228(1) physically contacts the large contact pad 252(1). In this manner, the testing interface 250 can aid in testing the DUT 240 for certain failure modes (e.g., shorts with a ground signal) and/or improve signal integrity.

In various embodiments, the testing module 134 receives one or more measurement RF signals from the receiving RF probe carrier 224(2) and analyzes the measurement RF signals to identify potential failure conditions. Such failure conditions include full defects, such as an open condition (e.g., loss of connectivity due to non-conductance) and/or a short condition (e.g., extra connectivity due to unwanted conductance with a second line). The failure conditions can also include partial defects, such as a resistive open condition (e.g., partial loss) and/or a resistive short (e.g., partial extra connectivity). Such conditions can also be associated with connections to a specific line, such as a short to a ground signal or an open to the power line. In various embodiments, the testing module 134 identifies the DUT 240 as faulty upon identifying at least one failure condition in any IUT included in the DUT 240. Alternatively, the testing module 134 can identify a potential failure condition for a given IUT (e.g., the wire 244) and flag the analysis for further review. Additionally, or alternatively, the testing module 134 can deduce a cause for the failure, such as a spatial pattern to identify which wires 244 failed, a strength indication to determine the number of full defects compared to resistive defects, and/or any differences in symmetry of results.

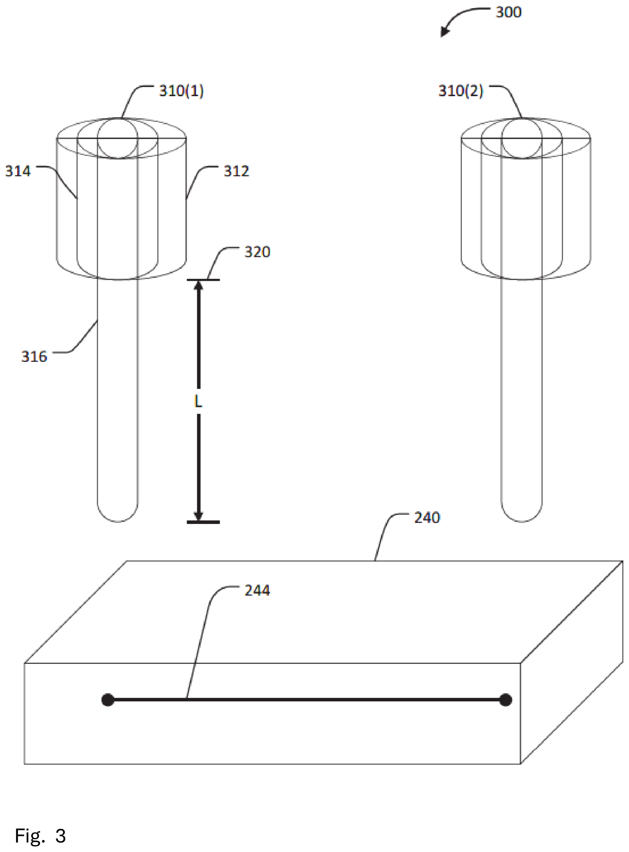

Figure 3 illustrates example RF probes 226 of the contactless testing system 200 of Figure 2 in proximity to the wire 244 of the DUT 240, according to various embodiments. As shown, the configuration 300 includes the RF probe portions 310 and the DUT 240. The RF probe portion 310 includes, without limitation, an outer isolation layer 312, an inner isolation layer 314, and an inner probe 316.

In various embodiments, the RF probe portion 310 includes the portion of the RF probe carrier 224 that includes the contactless probe 226 and one or more isolation layers (e.g., isolation layers 312, 314). The isolation layers 312, 314 are configured to provide shielding and/or protection between the contactless probe 226 and the DUT 240. For example, one or more of the isolation layers 312, 314 can include a nonconductive and/or RF shielding material (e.g., silicon nitride) that improves the capacitive coupling between the contactless probe 226 and the DUT 240. The isolation layers 312, 314 can also include one or more shielding layers to minimize crosstalk between probes 226 and/or contact pads 242.

In various embodiments, the inner probe 316 is a portion of the probe 226 that comprises an extendible wire or cable (e.g., a coaxial cable) that can extend a length 320 relative to the end of the inner isolation layer 314. In some embodiments, the RF probe carrier 224 causes the probe 226 to extend the inner probe 316. Extension of the inner probe 316 improves the sensitivity of the contactless probe 226 and raises the signal strength of the test RF signal. In such instances, the increased signal strength of the test RF signal increases the likelihood of inducing a current in the wire 244 and/or increases the signal strength of the measurement RF signal measured from the wire 244.

Additionally, or alternatively, in some embodiments, the RF probe portion 310 can move to contact the DUT 240 when establishing a capacitive coupling with a contact pad 242 of the DUT 240. In such instances, the RF probe portion 310 contacts the DUT 240 using a small amount of force (e.g., a "soft touch") such that the physical connection does not damage the DUT 240. This physical contact contrasts with the physical contact necessary for a direct electrical connection, as more force is needed to form a reliable electrical circuit between the RF probe portion 310 and the DUT 240. In some embodiments, the RF probe 266 and/or the contactless testing system 200 includes components to enable the physical connection, such as a spring layer, one or more buckling mechanisms (e.g., needles), a sense unit and/or a physical connection to a sense unit, and/or other components that detect physical attributes (e.g., force detection, capacitive detection, conductive detection, etc.) to detect when the RF probe portion 310 is physically contacting the DUT 240. In such instances, the RF probe carrier 224 can move the RF probe 226 away from the DUT 240 such that a probe distance 230 is formed between the end of the RF probe portion 310 and the surface of the DUT 240. In this manner, the probe distance 230 is lowered, improving the signal strength between the RF probe 226 and the wire under test.

In various embodiments, the inner probe 316 couples with the wire 244 included in the DUT 240 to form a signal path. When the RF tester 212 generates the test RF signal, the test RF signal can have a high frequency (e.g., 5-20 GHz) such that the signal characteristics of the test RF signal change based on the length of the signal path. To modify the operation of the signal path, the inner probe 316 can extend from the inner isolation layer 314 to modify the length of the signal path and/or modify the probe distance 230 between the distal end of the inner probe 316 and the target contact pad 242 at the end of the wire 244. For example, the test RF signal may include one or more resonant frequencies that are at least based on the length of the signal path. In such instances, the RF control module 132 can determine a target length of the signal path and cause the length 320 of the inner probe 316 to be adjusted to adjust the length of the signal path to approximately match the target length.

The RF probes 226 including the probe portions 310 are one example of probes that can be included in the contactless testing system 100. In various embodiments, the contactless testing system 100 can include other topologies that include other types of probes in addition to, or in lieu of, the RF probes 226 that include the probe portions 310. For example, the contactless testing system 100 can include probes that include various types of conductors, such as coaxial, transverse electromagnetic (TEM), and/or quasi-TEM interfaces. Additionally, or alternatively, in various embodiments, the end of the conductor can be cut, where the open surface of the conductor is exposed to the DUT 240. In such instances, the probe does not contact the DUT 240 and enables coupling with the DUT 240.

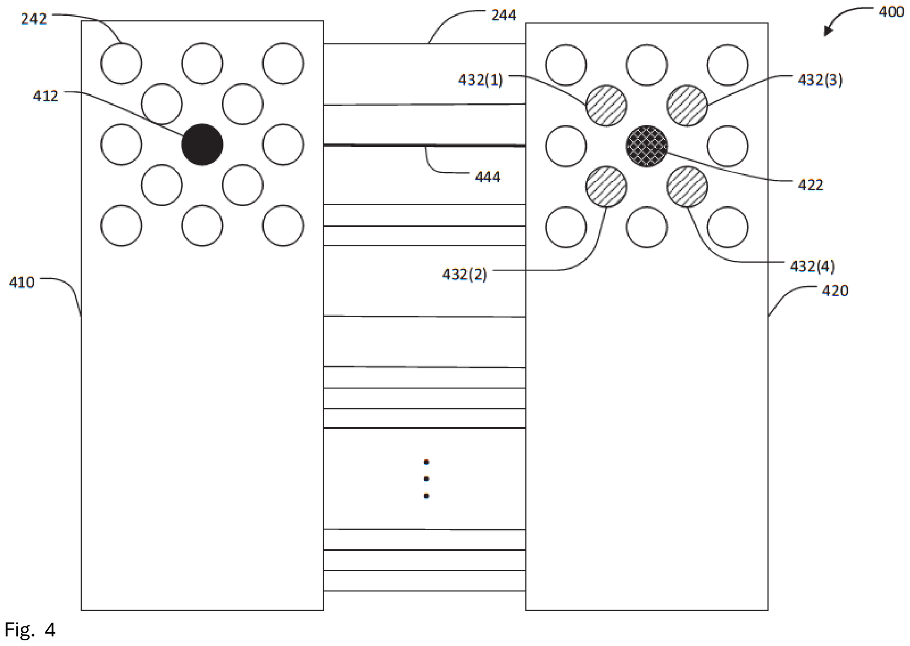

Figure 4 illustrates a testing arrangement for a plurality of contact pads 242 of a DUT 240 of Figure 2, according to various embodiments. As shown, the testing arrangement 400 includes, without limitation, a first interface 410, a second interface 420, a plurality of wires 244, and a wire under test (WUT) 444. The first interface 410 includes, without limitation, a plurality of contact pads 242. The plurality of contact pads 242 includes, without limitation, a source contact pad 412. The second interface 420 includes, without limitation, a plurality of contact pads 242. The plurality of contact pads 242 includes, without limitation, a receiving contact pad 422 and a plurality of neighboring contact pads 432.

In various embodiments, the interfaces 410, 420 are portions of a common interposer or bridge. The contactless testing system 200 can test each of the plurality of wires 244 by identifying the pairs of contact pads 242 on each end of an IUT, such as the WUT 444, and performing electrical tests. For example, the WUT 444 includes the source contact pad 412 on a first end and a receiving contact pad 422 on a second end.

In operation, the contactless testing system 200 can couple to multiple contact pads 242 when performing tests associated with the WUT 444. For example, multiple contactless probes 226(5)-226(8) of the receiving RF probe carrier 224(2) can couple with the receiving contact pad 422 and the neighboring contact pads 432 (e.g., 432(1)-432(4)), respectively. The source RF probe carrier 224(1) induces a current in the WUT 444 due to a coupling between the source contact pad 412 and a probe 226 on the source RF probe carrier 224(1). The receiving RF probe carrier 224(2) can measure one or more measurement RF signals that correspond to any current transmitted by the WUT 444 and/or one or more neighboring wires 244. In such instances, a measurement RF signal on the WUT 444 below a threshold indicates a failure condition of open or resistive open, and measurement RF signals on the neighboring wires 244 above a threshold indicate a failure condition of short or resistive short.

In various embodiments, the contactless testing system 200 can perform a testing sweep of the plurality of contact pads 242 by successively selecting the source and receiving contact pads 412, 422. For each receiving contact pad 422, the receiving RF probe carrier 224(2) couples to one or more neighboring contact pads 432 and tests for failure conditions. In this manner, the contactless testing system 200 can test for multiple failure conditions and accurately identify failure and failure conditions for any of the plurality of wires 244. For example, the testing module 134 can identify one or more full shorts and/or resistive shorts based on analyzing the spectral energy included in a given measurement RF signal.

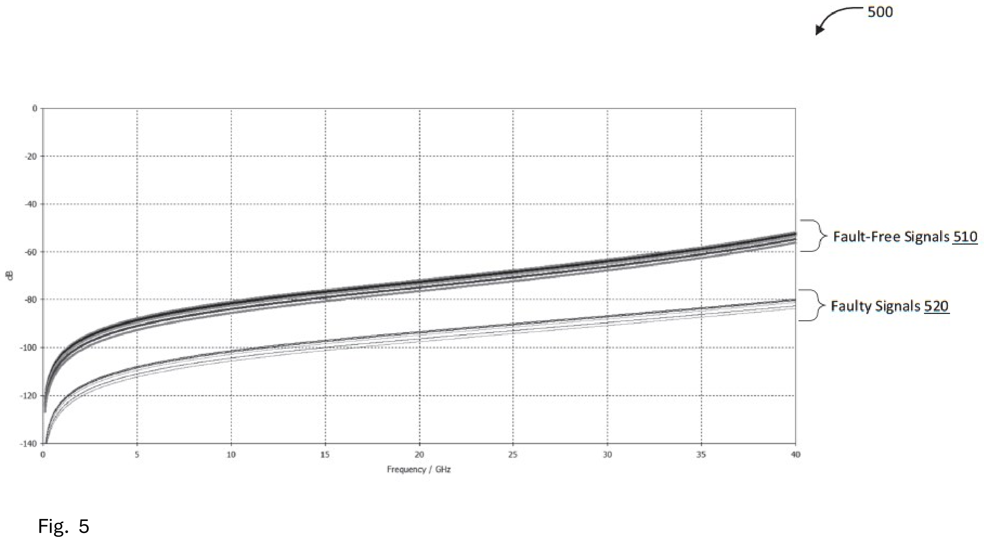

Figure 5 illustrates a graph 500 of a plurality of measurement RF signals received by the contactless testing system 200 of Figure 2, according to various embodiments. As shown, the graph 500 includes a plurality of fault-free signal 510 and a plurality of faulty signals 520.

In operation, the testing module 134 collects one or more measurement RF signals received by the receiving RF probe carrier 224(2). For example, the testing module 134 assesses the conductivity of a plurality of signal lines (a subset of the wires 244) included in the DUT 240. The measurement RF signals correspond to a plurality of signal wires 244 tested during the testing procedure. The testing module compares the measurement RF signals to identify any failure mode behaviors. In some embodiments, the contactless testing system 200 increases the accuracy of the assessment by repeating measurements using a sweep of frequencies. For example, the graph 500 can be a plurality of measurement RF signals corresponding to tests of multiple wires 244, or can be a plurality of measurement RF signals corresponding to multiple tests of the same wires 244.

As shown, the graph 500 includes a clear separation of signal strength between the plurality of signals 510 and the plurality of signals 520. In such instances, the testing module 134 identifies the plurality of signals 520 as faulty due to the difference in signal strength compared to the plurality of fault-free signals 510. In some embodiments, the testing module 134 can compare the signal strengths of the plurality of faulty signals 520 with historical data to classify the condition as a full short or a resistive short. The testing module 134 can perform other assessments. For example, the testing module 140 can classify wires associated with measurement RF signals above a threshold as an open condition or a resistive open condition when the signal strength is above an expected threshold.

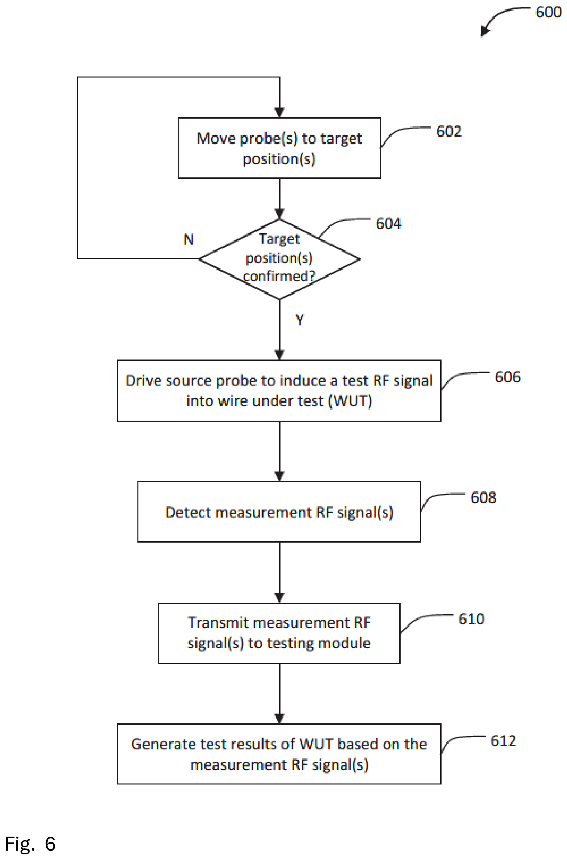

Figure 6 is a flow diagram of method steps for testing of a device under test, according to various embodiments. Although the method steps are described in conjunction with the embodiments of Figures 1-5, persons of ordinary skill in the art will understand that any system configured to perform the method steps, in any order, is within the scope of the invention.

As shown, a method 600 begins at step 602, where a contactless testing system contactless testing system moves an RF probe to a target position. In various embodiments, an RF control module 132 included in the contactless testing system 200 generates one or more commands that move one or more RF probe carriers 224 included in the contactless testing system 200 to one or more target positions and/or target orientations. The positioning of the one or more RF probe carriers 224 enables a plurality of contactless probes 226 to be proximate to contact pads 242 on the DUT 240 for capacitive coupling. The one or more contact pads 242 correspond to one or more WUTs 444 that are to be tested.

At step 604, the contactless testing system verifies whether the one or more RF probe carriers 224 are at the target position and/or the target orientation. In various embodiments, the RF control module 132 acquires sensor data (e.g., image data, laser measurements, sonic data, mechanical data, magnetic data, etc.) to determine the position of the one or more contactless probes 226 along the x, y, and z axes, as well as determine an orientation (e.g., tilt relative to a plane of the testing device 140 and/or the DUT 150) of the one or more respective contactless probes 226. The RF control module 132 can then use the location and orientation to verify whether a given contactless probe 226 is at a probe distance 230 that is proximate to the target contact pad 242. When the RF control module 132 determines that the one or more contactless probe 226 is at the target position and/or the target orientation, the contactless testing system 200 proceeds to step 606. Otherwise, when the RF control module 132 determines that the one or more probes 226 is not at the target position or orientation, the RF control module 132 returns to step 602, where the RF control module 132 can send one or more commands to the RF switch 222 and/or the RF probe carrier 224 to adjust the position of the RF probe carrier 224, the contactless probe 226, and/or the DUT 150. In such instances, the RF control module 132 can iteratively perform steps 602-604 by processing data acquired by the probe card 220 and generate commands to adjust the RF probe carriers 224 and/or the contactless probes 226 before completing verification.

At step 606, the contactless testing system drives the source probe to induce a test RF signal into a wire under test (WUT). In various embodiments, the RF control module 132 drives an RF tester 212 to generate a test RF signal. The test RF signal transmits along a signal path through the probe card 220, the source RF probe carrier 224(1), and a source contactless probe 226(1). Due to the coupling between the source contactless probe 226(1) and a source contact pad 412, the source contactless probe 226(1) induces a current in a WUT 444 connected to the source contact pad 412. In some embodiments, the RF control module 132 can perform parallel testing of multiple WUTs 444 by driving the RF tester 212 to generate multiple test RF signals (e.g., a distinct test RF signal for each contact pad 242 coupled to the RF probe carrier 224). In such instances, the plurality of test RF signals includes a first set of test RF signals for the WUTs 444, as well as one or more test RF signals for neighboring wires 244. The neighboring wires 244 can be measured to identify potential shorts due to interference.

At step 608, the contactless testing system detects one or more measurement RF signals. In various embodiments the receiving RF probe carrier 224(2) receives, via one or more couplings of receiving contactless probes 226(5)-226(8) to one or more receiving contact pads 242, one or more measurement RF signals. A given measurement RF signal corresponds to a current in a given WUT 444. For example, when performing parallel testing of a plurality of WUTs 444, the receiving probe carrier 224(2) includes a plurality of receiving probes 226(5)-226(8) coupled to a plurality of receiving contact pads 242 (e.g., 422, 432(1)-432(4)). When the plurality of source contactless probes 226(1)-226(3) induces a plurality of current in the WUTs 444 and neighboring wires 244, the receiving probe carrier 224(2) can measure a plurality of measurement RF signals that correspond to the respective currents transmitted by the WUTs 444 and/or any neighboring wires 244.

At step 610, the contactless testing system transmits the one or more measurement RF signals to a testing module. In various embodiments, the one or more measurement RF signals detected by the receiving RF probe carrier 224(2) are transmitted via the probe card 220 and/or the RF tester 212 to the testing module 134. In some embodiments, the receiving RF probe carrier 224(2) receives multiple measurement RF signals in parallel. In such instances, the receiving RF probe carrier 224(2) can send each of the measurement RF signals in parallel. Alternatively, in some embodiments, the RF probe carrier 224(2) aggregates groups of measurement RF signals and transmits the aggregated group of measurement RF signals to the testing module 134.

At step 612, the contactless testing system generates test results for the WUT based on the one or more measurement RF signals. In various embodiments, the testing module 134 analyzes the one or more received measurement RF signals to identify any failures associated with the WUT 444 and determines whether the DUT 240 is faulty. For example, the testing module 134 identifies the DUT 240 as faulty upon identifying a one failure condition associated with the WUT 444. Alternatively, in some embodiments, the testing module 134 can identify a potential failure condition for the WUT 444 and flag the analysis for further review. Additionally, or alternatively, the testing module 134 can deduce a cause for the failure, such as a spatial pattern to identify which wires 244 failed, a strength indication to determine the number of full defects compared to resistive defects, and/or any differences in symmetry of results. Upon generating test results for the WUT 444, the contactless testing system can return to step 602 to move the contactless probes 226 to test one or more different WUTs 444. In some embodiments, steps 602-612 are performed continually. In such instances, the testing module 134 can receive and analyze measurements while the contactless probes 226 are moving. Alternatively, one or more of steps 602-612 are performed stepwise. For example, the contactless testing system can complete step 612 before returning to step 602 to move the contactless probe 226.

In sum, the contactless testing system disclosed herein enables interface routes of interposers and silicon bridges to be tested and evaluated without requiring contact with any leads, contact pads, solder balls, or pins. The contactless testing system includes a plurality of RF probes that are configured to establish a capacitive coupling with a contact lead of a device under test, such as an interposer. During testing, a probe card connected to the RF probes responds to commands by moving the RF probes to a desired location and a desired position proximate to a target contact lead on the device under test. The probe card moves the RF probes along the x-axis, y-axis, and/or z-axis and/or can tilt the RF probes to modify orientations relative to the device under test and/or any of its components. In an alternative embodiments, the probe carriers or probes also moves relative to each other. A given RF probe includes a flexible connection to the testing system to change the distance between the distal end of the RF probe and the contact pad. Once at the target positions, a source RF probe couples with a first contact pad and a receiving RF probe couples with a second contact pad, each without making contact. An RF tester generates a test signal at a selected frequency. The source RF probe induces the wire connected to the contact pad to transmit the test signal. The receiving RF probe receives a measurement RF signal from the second contact pad. In some embodiments, the contactless testing system generates multiple RF test signals in parallel and receives multiple measurement RF signals. The probe transmits the measurement RF signal to a testing module. The testing module analyzes one or more measurement RF signals and identifies any performance test failures. The testing module provides one or more the measurement RF signals, and the performance test results for evaluation of the device under test.

At least one technical advantage of the disclosed techniques relative to the prior art is that, with the disclosed techniques, interposers, silicon bridges, and other electronic equipment can be tested quickly and accurately using a contactless approach without the need of bulky and costly imaging-based systems. In particular, the contactless approach moves probes proximate to the DUT and performs one or more electrical tests that typically require contact between a pair of contact points on the DUT and the testing system. In this manner, a testing system using the contactless approach can acquire accurate results without damaging the DUT or introducing false measurements due to contact errors. The disclosed techniques also accurately identify faults, such as opens, shorts, and potential failures of neighboring wires, at greater speeds and at lower costs than conventional contactless testing systems. Further, the disclosed techniques can identify functioning wires and faults with greater accuracy. These technical advantages provide one or more technological advancements over prior art approaches.
1. In various embodiments, a testing system comprises automated test equipment, and a probe card coupled to the automated test equipment, the probe card including a first probe, where the automated test equipment is configured to move a first probe proximate to a first contact of a device under test (DUT), where the first contact is connected to a wire, move a second probe proximate to a second contact of the DUT, drive the first probe with a first RF signal to induce a second RF signal in the wire, measure, via the second probe, the second RF signal, and generate a test result based on at least the second RF signal.
2. The testing system of clause 1, where the DUT comprises an interposer or a silicon bridge.
3. The testing system of clause 1 or 2, where the second contact comprises a receiving contact that is connected via the wire to the first contact.
4. The testing system of any of clauses 1-3, where the automated test equipment is further configured to measure additional RF signals that are associated with a neighboring contact that is proximate to the second contact, where the neighboring contact that is not connected to the first contact.
5. The testing system of any of clauses 1-4, further comprising a plurality of probes coupled to the probe card, where none of the plurality of probes contact the DUT, and the first probe included in the plurality of probes includes an extendible cable that modifies a probe distance between a distal end of the first probe and the first contact.
6. The testing system of any of clauses 1-5, where the automated test equipment is configured to modify the probe distance to change a signal path from a first signal path length to a second signal path length, and the second RF signal includes a resonant frequency when recorded at the second signal path length.
7. The testing system of any of clauses 1-6, further comprising a testing interface that includes one or more testing contacts, where a first testing contact of the one or more testing contacts is configured to be electrically coupled with one of the first contact or the second contact, where the probe card includes at least one contact probe that physically contacts the first testing contact.
8. The testing system of any of clauses 1-7, where the probe card includes a probe that is configured to tilt relative to a plane of the DUT.
9. The testing system of any of clauses 1-8, where the automated test equipment is further configured to measure in parallel one or more additional RF signals associated with one or more neighboring contacts that are proximate to the second contact, where the test result is based at least on the second RF signal and the one or more additional RF signals, and the test result is one of an open condition, a short condition, a resistive open condition, a resistive short condition, or a resonant frequency.
10. The testing system of any of clauses 1-9, where the test result includes a strength indication associated with a first number of full defects and a second number of resistive defects.
11. In various embodiments, a computer-implemented method for testing an interposer or silicon bridge comprises moving, by automated test equipment, a first probe proximate to a first contact of a device under test (DUT), moving, by the automated test equipment, a second probe proximate to a second contact of the DUT, where the first contact and second contact are connected via a wire, driving, by the automated test equipment, the first probe with a first RF signal to induce a second RF signal in the wire, measuring, by the automated test equipment via the second probe, the second RF signal, and generating, by the automated test equipment, a test result based on at least the second RF signal.
12. The computer-implemented method of clause 11, where the test result is one of an open condition, a short condition, a resistive open condition, a resistive short condition, or a resonant frequency.
13. The computer-implemented method of clause 11 or 12, further comprising measuring, in parallel, one or more additional RF signals associated with one or more neighboring contacts that are proximate to the second contact.
14. The computer-implemented method of any of clause 11-13, further comprising generating, by automated test equipment, a test result based at least on the second RF signal and the one or more additional RF signals, where the test result is one of an open condition, a short condition, a resistive open condition, a resistive short condition, or a resonant frequency.
15. The computer-implemented method of any of clause 11-14, where the test result includes a spatial pattern identifying one or more wires that failed.
16. The computer-implemented method of any of clause 11-15, where the second contact comprises a receiving contact that is connected via a first wire to the first contact.
17. The computer-implemented method of any of clause 11-16, where a plurality of probes is coupled to a probe card that is coupled to the automated test equipment, none of the plurality of probes contact the DUT, and a first probe included in the plurality of probes includes an extendible cable that modifies a probe distance between a distal end of the first probe and the first contact.
18. The computer-implemented method of any of clause 11-17, further comprising modifying the probe distance to change a signal path from a first signal path length to a second signal path length, and the second RF signal includes a resonant frequency when recorded at the second signal path length.
19. The computer-implemented method of any of clause 11-16, where at least one of the first probe or the second probe is configured to tilt relative to a plane of the DUT.
20. In various embodiments, one or more non-transitory computer-readable media store program instructions that, when executed by one or more processors, cause the one or more processors to perform a method comprising moving, by automated test equipment, a probe proximate to a first contact of a device under test (DUT), moving, by the automated test equipment, a second probe proximate to a second contact of the DUT, wherein the first contact and second contact are connected via a wire, driving, by the automated test equipment, the first probe with a first RF signal to induce a second RF signal in the wire, measuring, by the automated test equipment via the second probe, the second RF signal, and generating, by the automated test equipment, a test result based on at least the second RF signal.

Any and all combinations of any of the claim elements recited in any of the claims and/or any elements described in this application, in any fashion, fall within the contemplated scope of the present invention and protection.

The descriptions of the various embodiments have been presented for purposes of illustration, but are not intended to be exhaustive or limited to the embodiments disclosed. Many modifications and variations will be apparent to those of ordinary skill in the art without departing from the scope and spirit of the described embodiments.

Aspects of the present embodiments can be embodied as a system, method or computer program product. Accordingly, aspects of the present disclosure can take the form of an entirely hardware embodiment, an entirely software embodiment (including firmware, resident software, micro-code, etc.) or an embodiment combining software and hardware aspects that can all generally be referred to herein as a "module," a "system," or a "computer." In addition, any hardware and/or software technique, process, function, component, engine, module, or system described in the present disclosure can be implemented as a circuit or set of circuits. Furthermore, aspects of the present disclosure can take the form of a computer program product embodied in one or more computer readable medium(s) having computer readable program code embodied thereon.

Any combination of one or more computer readable medium(s) can be utilized. The computer readable medium can be a computer readable signal medium or a computer readable storage medium. A computer readable storage medium can be, for example, but not limited to, an electronic, magnetic, optical, electromagnetic, infrared, or semiconductor system, apparatus, or device, or any suitable combination of the foregoing. More specific examples (a non-exhaustive list) of the computer readable storage medium would include the following: an electrical connection having one or more wires, a portable computer diskette, a hard disk, a random access memory (RAM), a read-only memory (ROM), an erasable programmable read-only memory (EPROM or Flash memory), an optical fiber, a portable compact disc read-only memory (CD-ROM), an optical storage device, a magnetic storage device, or any suitable combination of the foregoing. In the context of this document, a computer readable storage medium can be any tangible medium that can contain, or store a program for use by or in connection with an instruction execution system, apparatus, or device.

Aspects of the present disclosure are described above with reference to flowchart illustrations and/or block diagrams of methods, apparatus (systems) and computer program products according to embodiments of the disclosure. It will be understood that each block of the flowchart illustrations and/or block diagrams, and combinations of blocks in the flowchart illustrations and/or block diagrams, can be implemented by computer program instructions. These computer program instructions can be provided to a processor of a general purpose computer, special purpose computer, or other programmable data processing apparatus to produce a machine. The instructions, when executed via the processor of the computer or other programmable data processing apparatus, enable the implementation of the functions/acts specified in the flowchart and/or block diagram block or blocks. Such processors can be, without limitation, general purpose processors, special-purpose processors, application-specific processors, or field-programmable gate arrays.

The flowchart and block diagrams in the figures illustrate the architecture, functionality, and operation of possible implementations of systems, methods and computer program products according to various embodiments of the present disclosure. In this regard, each block in the flowchart or block diagrams can represent a module, segment, or portion of code, which comprises one or more executable instructions for implementing the specified logical function(s). It should also be noted that, in some alternative implementations, the functions noted in the block can occur out of the order noted in the figures. For example, two blocks shown in succession may, in fact, be executed substantially concurrently, or the blocks can sometimes be executed in the reverse order, depending upon the functionality involved. It will also be noted that each block of the block diagrams and/or flowchart illustration, and combinations of blocks in the block diagrams and/or flowchart illustration, can be implemented by special purpose hardware-based systems that perform the specified functions or acts, or combinations of special purpose hardware and computer instructions.

While the preceding is directed to embodiments of the present disclosure, other and further embodiments of the disclosure can be devised without departing from the basic scope thereof, and the scope thereof is determined by the claims that follow.

## Claims

1. A testing system comprising:
automated test equipment; and
a probe card coupled to the automated test equipment, the probe card including a first probe;
wherein the automated test equipment is configured to:
move a first probe proximate to a first contact of a device under test, DUT, wherein the first contact is connected to a wire;
move a second probe proximate to a second contact of the DUT;
drive the first probe with a first RF signal to induce a second RF signal in the wire;
measure, via the second probe, the second RF signal; and
generate a test result based on at least the second RF signal.

2. The testing system of claim 1, wherein the DUT comprises an interposer or a silicon bridge.

3. The testing system of either claim 1 or claim 2, wherein the second contact comprises a receiving contact that is connected via the wire to the first contact.

4. The testing system of any one of claims 1 to 3, wherein the automated test equipment is further configured to measure additional RF signals that are associated with a neighboring contact that is proximate to the second contact, wherein the neighboring contact that is not connected to the first contact.

5. The testing system of any one of claims 1 to 4, further comprising a plurality of probes coupled to the probe card, wherein:
none of the plurality of probes contact the DUT; and
the first probe included in the plurality of probes includes an extendible cable that modifies a probe distance between a distal end of the first probe and the first contact, wherein:
the automated test equipment is preferably configured to modify the probe distance to change a signal path from a first signal path length to a second signal path length; and
the second RF signal includes a resonant frequency when recorded at the second signal path length.

6. The testing system of any one of claims 1 to 5, further comprising:
a testing interface that includes one or more testing contacts, wherein a first testing contact of the one or more testing contacts is configured to be electrically coupled with one of the first contact or the second contact,
wherein the probe card includes at least one contact probe that physically contacts the first testing contact.

7. The testing system of any one of claims 1 to 6, wherein the probe card includes a probe that is configured to tilt relative to a plane of the DUT and/or wherein the test result includes a strength indication associated with a first number of full defects and a second number of resistive defects.

8. The testing system of any one of claims 1 to 7, wherein the automated test equipment is further configured to measure in parallel one or more additional RF signals associated with one or more neighboring contacts that are proximate to the second contact, wherein:
the test result is based at least on the second RF signal and the one or more additional RF signals, and
the test result is one of an open condition, a short condition, a resistive open condition, a resistive short condition, or a resonant frequency.

9. A computer-implemented method for testing an interposer or silicon bridge, the method comprising:
moving, by automated test equipment, a first probe proximate to a first contact of a device under test, DUT;
moving, by the automated test equipment, a second probe proximate to a second contact of the DUT, wherein the first contact and second contact are connected via a wire;
driving, by the automated test equipment, the first probe with a first RF signal to induce a second RF signal in the wire;
measuring, by the automated test equipment via the second probe, the second RF signal; and
generating, by the automated test equipment, a test result based on at least the second RF signal.

10. The computer-implemented method of claim 9, wherein the test result is one of an open condition, a short condition, a resistive open condition, a resistive short condition, or a resonant frequency.

11. The computer-implemented method of either claim 9 or claim 10, further comprising measuring, in parallel, one or more additional RF signals associated with one or more neighboring contacts that are proximate to the second contact, and preferably further comprising:
generating, by automated test equipment, a test result based at least on the second RF signal and the one or more additional RF signals,
wherein the test result is one of an open condition, a short condition, a resistive open condition, a resistive short condition, or a resonant frequency.

12. The computer-implemented method of any one of claims 9 to 11, wherein the test result includes a spatial pattern identifying one or more wires that failed, and/or wherein the second contact comprises a receiving contact that is connected via a first wire to the first contact.

13. The computer-implemented method of any one of claims 9 to 12, wherein:
a plurality of probes is coupled to a probe card that is coupled to the automated test equipment;
none of the plurality of probes contact the DUT; and
a first probe included in the plurality of probes includes an extendible cable that modifies a probe distance between a distal end of the first probe and the first contact, further preferably comprising:
modifying the probe distance to change a signal path from a first signal path length to a second signal path length; and
the second RF signal includes a resonant frequency when recorded at the second signal path length.

14. The computer-implemented method of any one of claims 9 to 13, wherein at least one of the first probe or the second probe is configured to tilt relative to a plane of the DUT.

15. One or more non-transitory computer-readable media storing program instructions that, when executed by one or more processors, cause the one or more processors to perform a method comprising:
moving, by automated test equipment, a probe proximate to a first contact of a device under test, DUT;
moving, by the automated test equipment, a second probe proximate to a second contact of the DUT, wherein the first contact and second contact are connected via a wire;
driving, by the automated test equipment, the first probe with a first RF signal to induce a second RF signal in the wire;
measuring, by the automated test equipment via the second probe, the second RF signal; and
generating, by the automated test equipment, a test result based on at least the second RF signal.
